# EUROPÄISCHE PATENTSCHRIFT

(11) **EP 2 350 758 B1**
(45) Veröffentlichungstag und Bekanntmachung des Hinweises auf die Patenterteilung: **17.04.2013**
(21) Anmeldenummer: 09760832.7
(22) Anmeldetag: 23.11.2009
(51) Int. Cl.: G05B 23/02, G01N 27/416

(54) **VERFAHREN ZUR ÜBERWACHUNG EINER POTENTIOMETRISCHEN MESSSONDE**
METHOD FOR MONITORING A POTENTIOMETRIC MEASURING PROBES
PROCÉDÉ DE SURVEILLANCE DE SONDES DE MESURES POTENTIOMÉTRIQUES

(30) Priorität: 24.11.2008 DE 102008058804
(43) Veröffentlichungstag der Anmeldung: 03.08.2011
(73) Patentinhaber: Mettler-Toledo AG, 8606 Greifensee (CH)
(72) Erfinder: EHRISMANN, Philippe, 8610 Uster (CH)
(86) Internationale Anmeldenummer: PCT/EP2009/065644
(87) Internationale Veröffentlichungsnummer: WO 2010/058007

(56) Entgegenhaltungen:
- DE-C1- 19 510 574

## Beschreibung

Die Erfindung betrifft ein Verfahren zur Überwachung einer Messsonde, insbesondere einer ionensensitiven, amperometrischen, potentiometrischen oder optischen Messsonde.

Beispiele für solche Messsonden stellen unter anderem pH-, O₂-, CO₂- oder Leitfähigkeits-Messsonden dar, welche sowohl im Laborbereich als auch für die Überwachung und Steuerung von Prozessanlagen in vielfältigen Industriezweigen eingesetzt werden, zu denen neben der chemischen und pharmazeutischen Industrie beispielsweise auch die Lebensmittelindustrie und die kosmetische Industrie zählen.

Es ist hinlänglich bekannt, dass derartige Messsonden im Laufe der Zeit altern oder ihre Funktionalität auf Grund von mit dem Messmedium oder im Messmedium auftretenden Ereignissen verändern. Die Messsonde kann beispielsweise durch aggressive Messmedien angegriffen oder unter extremen Prozessbedingungen verändert werden. Im Fall einer pH-Messsonde kann das Messmedium zum Beispiel über eine Flüssigkeitsschranke (eng. liquid junction) in die Messsonde eindringen und deren Komponenten verändern.

Zur Abschätzung dieser, die Messsonde verändernden Ereignisse sind bereits verschiedene Ansätze und Verfahren bekannt.

Die DE 102 09 318 A1 offenbart ein Verfahren zur rechnerischen Ermittlung der verschleissabhängigen Restlebenszeit einer elektrochemischen Messsonde. Das Verfahren beruht darauf, dass sich der Verschleiss einer Messsonde in der Veränderung eines oder mehrerer für ihre Funktion relevanter Parameter äussert. Als Parameter werden verschiedene Kalibrierparameter einer pH- oder Sauerstoff-Messsonde herangezogen.

Die EP 1 550 861 A1 offenbart ein Verfahren, mit welchem der Zustand einer Messsonde unter Berücksichtigung äusserer Temperatureinflüsse, wie sie beim Reinigen der Messsonde unter Prozessbedingungen auftreten, gemessen werden kann.

Die erwähnten Verfahren stützen sich vor allem auf eine Abschätzung der bereits erfolgten Ereignisse im Vergleich zu einer vorgegebenen Gesamtlebensdauer. Angaben über den aktuellen Zustand der Messsonde oder die Stabilität der Messwerte werden nicht angegeben.

Diese Gesamtlebensdauer ist im Allgemeinen ein auf Erfahrungswerten beruhender Schätzwert. In einer Prozessanlage wird häufig eine Vielzahl von Messsonden eingesetzt. Jeder vorzeitige und damit unnötige Austausch einer Messsonde erhöht die Prozesskosten. Im ungünstigen Fall kann ein Ausfall einer Messsonde sogar zu einer Unterbrechung des Prozesses führen.

Die EP 1 176 419 A2 beschreibt eine pH-Messsonde mit zwei Referenzelementen, die so angeordnet sind, dass eine Verarmung des Elektrolyten das eine Referenzelement vor dem anderen Referenzelement erreicht.

Die EP 1 219 959 A1 beschreibt ebenfalls eine pH-Messsonde mit zwei Referenzelementen, wobei die Referenzelemente unterschiedlich stabil sind, so dass diese auf eine fortschreitende Verarmung des Elektrolyten unterschiedlich schnell reagieren.

Die Bestimmung der Verarmung des Elektrolyten benötigt somit eine bauliche Veränderung der Messsonde, zudem erfolgt keine Angabe über die Qualität und/oder Stabilität des Messsignals.

Die DE 195 10574 C1 offenbart ein Verfahren zur Zustandsbestimmung eines amperometrischen Gassensors. Die Zustandsbestimmung erfolgt, indem nach Unterbruch des externen Stromkreises der Gassensor mit dem nachzuweisenden Gas definiert beaufschlagt wird und nach erneutem Schliessen des Stromkreises das Einschaltverhalten des Sensorsignals erfasst und ausgewertet wird.

Für den Benutzer sind neben Informationen zur Funktionsfähigkeit und zur Restlebensdauer auch Informationen zum aktuellen Funktionszustand einer Messsonde und der Stabilität der erhaltenen Messwerte wichtig. Es wäre daher wünschenswert, den aktuellen Funktionszustand einer Messsonde ermitteln und präziser angeben zu können.

Gelöst wird diese Aufgabe durch ein Verfahren zur fortlaufenden Überwachung einer Messsonde, sowie durch ein Messsystem zur Durchführung dieses Verfahrens.

Das Verfahren zur Überwachung einer Messsonde, insbesondere einer ionensensitiven, amperometrischen, potentiometrischen oder optischen Messsonde, welche in Kontakt mit einem Messmedium steht und zur Erfassung mindestens eines Messwerts des Messmediums dient, weist mehrere Schritte auf. Zunächst werden zeitabhängig die Werte mindestens eines ersten Parameters bestimmt. Von diesen Werten werden jeweils die temporale Ableitung oder die Steigung und nachfolgend ein erster Betrag dieser Steigung berechnet. Der ermittelte erste Betrag wird mit einem ersten Grenzwert verglichen. Sobald der erste Betrag den ersten Grenzwert erreicht oder überschreitet, wird ein erster Zeitpunkt aufgezeichnet. Von diesem ersten Zeitpunkt an wird der erste Parameter solange überwacht bis der erste Betrag den ersten Grenzwert wieder unterschreitet, worauf ein zweiter Zeitpunkt aufgezeichnet wird. Von diesem zweiten Zeitpunkt an werden zeitabhängige Werte mindestens eines zweiten Parameters bestimmt, deren temporale Ableitung oder deren Steigung berechnet sowie ein zweiter Betrag dieser Steigung ermittelt. Der zweite Parameter wird nachfolgend solange überwacht, bis der zweite Betrag den zweiten Grenzwert unterschreitet, worauf ein dritter Zeitpunkt aufgezeichnet wird. Anhand der ermittelten ersten, zweiten und/oder dritten Zeitpunkte wird eine Überwachungsgrösse ermittelt. Das Verfahren beruht darauf, dass der erste Parameter schneller auf eine Änderung des Messmediums anspricht, als der zweite Parameter. Beide Parameter sind "sondenspezifische Parameter", also Parameter welche für die Messsonde spezifisch sind und/oder deren Qualität und/oder Genauigkeit sich bei einer Alterung der Messsonde verändern und deren Werte auf eine Veränderung des Messmediums und/oder der Messbedingungen ansprechen oder reagieren. Beim ersten und beim zweiten Parameter handelt es sich vorzugsweise um voneinander unabhängige Parameter, welche sich gegenseitig im Wesentlichen nicht beeinflussen.

Mit dem erfindungsgemässen Verfahren kann das spezifische Verhalten, die Stabilität sowie die Verlässlichkeit der Messwerte einer individuellen Messsonde anhand der Überwachung von mindestens zwei Parametern überwacht werden. Zudem können auch kurzfristig und/oder ungewollt auftretende Ereignisse mit der Messsonde erfasst werden.

Das erfindungsgemässe Verfahren kann zudem die Erfassung und Ermittlung der Werte mindestens eines weiteren Parameters umfassen, welche Werte mit denen des ersten und/oder zweiten Parameters in Bezug gesetzt werden. Somit kann das erfindungsgemässe Verfahren einen Vergleich des Verhaltens von Messwerten von zwei oder mehr sondenspezifischen Parametern umfassen.

In einem Ausführungsbeispiel des Verfahrens kann das relative Ansprechverhalten der Messsonde die Überwachungsgrösse sein. Die Ermittlung des relativen Ansprechverhaltens umfasst folgende Schritte: Erfassen eines ersten Messwerts am ersten Zeitpunkt und Erfassen eines zweiten Messwerts am dritten Zeitpunkt. Anschliessend wird die Differenz des ersten und zweiten Messwerts sowie die Differenz des dritten und ersten Zeitpunkts ermittelt.

Alternativ kann die Relation, bzw. das mathematische Verhältnis, des ersten Messwerts zu einem dritten und vierten Messwert ermittelt werden, welche an einem vierten oder fünften Zeitpunkt bestimmt oder ermittelt werden. Als vierter oder fünfter Zeitpunkt können die Zeitpunkte festgelegt oder ermittelt werden, an denen der Messwert der Sonde etwa 95% oder etwa 98% des Messwertsprungs oder des Unterschieds zwischen dem ersten und dem zweiten Messwert erreicht hat. Mittels des vierten und/oder des fünften Zeitpunkts kann eine sondenspezifische Grösse ermittelt werden, welche eine Aussage über die Ansprechzeit und somit auch über den Alterungszustand der Messsonde erlaubt.

Ein derartig ausgeführtes Verfahren zur Überwachung einer Messsonde ist vorteilhaft, da es im Wesentlichen unabhängig vom durch die Messsonde zu bestimmenden Messwert ist. Die Bestimmung der Funktionsfähigkeit der Messsonde hängt somit nur von den sondenspezifischen Parametern ab.

In einem weiteren Ausführungsbeispiel umfasst das Verfahren weiterhin das Speichern der ermittelten Überwachungsgrösse, zudem kann mittels dieser Grösse eine Abschätzung über die Restlebensdauer und/oder eine Alterung der Messsonde bestimmt werden.

Das Verfahren ermöglicht somit eine Bestimmung der Stabilität der Messwerte und eine Abschätzung darüber, wie stark die Messsonde gealtert ist und/oder wie lange diese wahrscheinlich noch funktioniert, so dass der Zeitpunkt des Austausches genauer bestimmt werden kann. Weiterhin werden Ereignisse erfasst, die beispielsweise zu einer Regeneration der Messsonde führen. Eine Regeneration der Messsonde kann sowohl aktiv als auch passiv geschehen. Eine aktive Regeneration wäre beispielsweise der Austausch des Elektrolyten einer pH-Messsonde oder der Ersatz der sauerstoffpermeablen Membran einer Sauerstoff-Messsonde. Eine passive oder zufällige Regeneration kann beispielsweise auch durch die eingesetzten Messmedien, Messbedingungen und/oder Reinigungsprozesse erfolgen.

Die Restlebensdauer oder Alterung der Messsonde kann zum Beispiel durch Vergleich der aktuellen Überwachungsgrösse mit einer optimalen Überwachungsgrösse ermittelt werden, welche einer von Hersteller angegebenen Spezifikation der Messsonde entspricht.

Die Bestimmung von mindestens zwei sondenspezifischen Parametern ermöglicht auch eine Aussage über die Funktionsfähigkeit der Messsonde. Ändert sich der Wert eines Parameters ohne das eine zeitnahe Änderung des Werts des anderen Parameters erfolgt, so kann daraus geschlossen werden, dass die Messsonde nicht mehr optimal funktioniert und somit überprüft und gegebenenfalls ausgetauscht werden sollte. Weitere Hinweise auf ein mögliches Fehlverhalten der Messsonde kann ein fehlendes oder zu langsames Einschwingen mindestens eines der überwachten Parameter nach einer Störung geben. Derartige Ereignisse können dem Benutzer gegebenenfalls zusammen mit Vorschlägen für das weitere Vorgehen angezeigt werden.

In einem weiteren Ausführungsbeispiel wird die Messwertstabilität als Überwachungsgrösse herangezogen. Anhand des erfassten ersten und dritten Zeitpunkts wird ein Zeitfenster ermittelt, in dem die Messsonde potentiell instabile Messwerte liefert. Es ist vorteilhaft, wenn der Benutzer durch eine Anzeige oder Mitteilung über dieses Zeitfenster informiert wird. Aufgrund dieser Informationen kann der Benutzer manuell oder mittels eines entsprechend angepassten automatisierten Verfahrens feststellen, welche Messwerte in diesem Zeitfenster aufgenommen wurden. Diese Messwerte sind potentiell instabil oder sogar falsch und können entsprechend markiert werden, so dass sie zum Beispiel bei einer Auswertung der Ergebnisse unberücksichtigt bleiben. Der Benutzer wird fortlaufend und/oder am Ende der Messung oder des Prozesses darüber informiert, wann die Ergebnisse instabil sind und weiss im Umkehrschluss somit auch, welche Messwerte ohne diese Unsicherheit aufgenommen wurden und somit stabil und verlässlich sind. Dieses erleichtert das Identifizieren von Ausreisser und gibt zudem Hinweise auf die Funktionsfähigkeit der Messsonde.

Die Überwachung der Stabilität und der Verlässlichkeit der Messwerte ist insbesondere bei Messsonden relevant, welche zur Bestimmung kritischer Komponenten verwendet werden, wie beispielsweise Sauerstoff. Die Funktionsfähigkeit einer Sauerstoff-Messsonde sollte ständig gewährleistet sein, insbesondere wenn diese in Bereichen eingesetzt wird, in denen das Vorliegen von Sauerstoff über einer bestimmten Konzentration zu einer Explosion führen könnte. Die Gewährleistung der Funktionalität wird auch als "Fail Safe" bezeichnet. Mit dem erfindungsgemässen Verfahren ist es möglich, die Funktionsfähigkeit sowie die Verlässlichkeit der Messwerte kontinuierlich und/oder in vorgegebenen Intervallen zu überwachen. Fehlerhafte Messsonden können einfach identifiziert und ausgetauscht werden. Ebenso können fehlerhafte Messwerte durch eine zusätzliche externe Messsonde zeitnah überprüft und so beispielsweise die Sicherheit in explosionsgefährdeten Bereichen verbessert werden.

Jede potentiometrische Messsonde weist verschiedene sondenspezifische Parameter auf, von denen die meisten im vorangehend beschriebenen Verfahren eingesetzt werden können. Bei der Wahl des ersten und zweiten Parameters sollte berücksichtigt werden, dass der Wert des ersten Parameters einer Änderung schneller folgt als der des zweiten Parameters und dass die Werte der Parameter durch eine Veränderung des Messmediums beeinflusst werden. Mögliche Kombinationen des ersten und zweiten Parameters umfassen beispielsweise das Oxidations-Reduktionspotential (ORP) und einen ersten Glaswert der Messsonde, einen ersten Referenzwert und einen zweiten Referenzwert, das Oxidations-Reduktionspotential und ein Messwertpotential, oder einen ersten schnellen Glaswert und einen zweiten langsamen Glaswert.

Besonders vorteilhaft ist die Durchführung des Verfahrens als dynamisches Verfahren, welches während des Betriebs der Messsonde durchgeführt werden kann. Auf diese Weise kann das Verfahren auch im laufenden Prozess durchgeführt werden und dadurch eine kontinuierliche Überwachung der Funktionalität der Messsonde und der Verlässlichkeit der Messwerte im Prozess gewährleistet werden.

Ein Messsystem zur Durchführung dieses Verfahrens weist eine Messsonde, insbesondere eine ionensensitive, amperometrische, potentiometrische oder optische Messsonde, mit einem Transmitter und einem Controller auf, wobei die Messsonde mit einem Messmedium in Kontakt steht und der Controller eine Computereinheit und mindestens ein Programm zur Ausführung des Verfahrens aufweist.

In einem bevorzugten Ausführungsbeispiel ist die Messsonde eine potentiometrische Messsonde mit einer Referenzelektrode und mindestens einem ionensensitiven Glas.

In einem weiteren Ausführungsbeispiel bilden der Controller und der Transmitter eine Einheit.

Das erfindungsgemässe Verfahren sowie das Messsystem werden im Folgenden anhand der Figuren näher beschrieben. Die Figuren zeigen:
- Fig. 1: Eine stark vereinfachte Darstellung des zeitlichen Verlaufs eines ersten und zweiten Parameterwerts einer Messsonde;
- Fig. 2: eine schematische Darstellung eines Verfahrens zur Überwachung einer potentiometrischen Messsonde durch Verfolgung eines ersten und eines zweiten Parameterwerts in Form eines Flussdiagramms;
- Fig. 3: eine Auftragung des ORP- und pH-Werts von zwei Messsonden (InPro 3250SG mit M700) als Funktion der Zeit während der Zugabe von Salzsäure zu einer wässrigen Lösung mit pH 7.

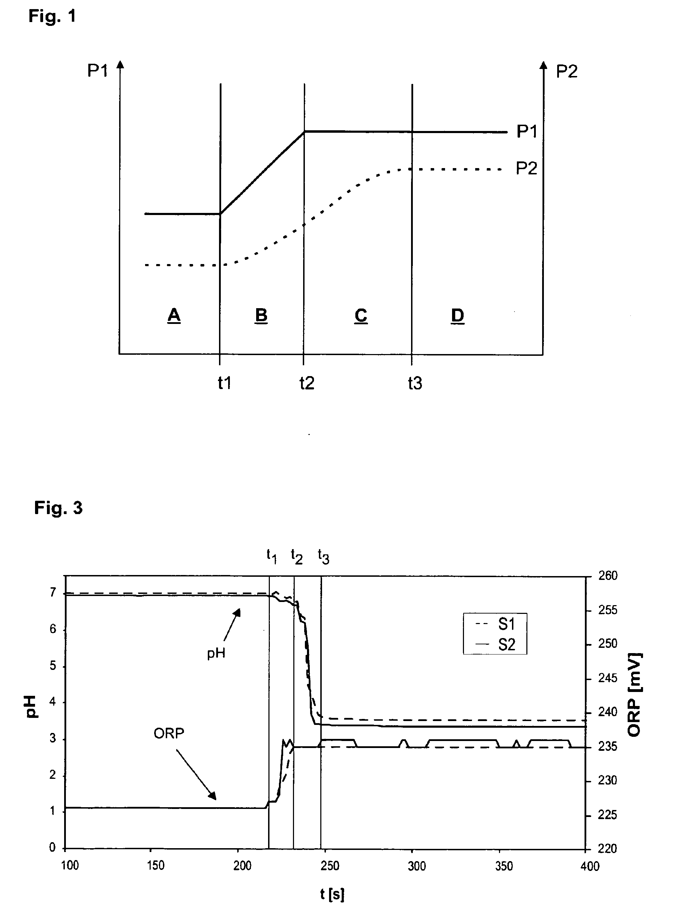

In Figur 1 ist schematisch der zeitliche Verlauf der Werte eines ersten Parameters P1 und eines zweiten Parameters P2 während eines sich verändernden Prozesses dargestellt. Beide Parameter P1, P2 sind sondenspezifische Parameter, welche im Wesentlichen von einander unabhängig sind. Die Änderungen der Werte dieser Parameter P1, P2 können beispielsweise Hinweise auf die Stabilität und/oder Verlässlichkeit von Messergebnissen und/oder auf die Funktionsfähigkeit der Messsonde geben.

In einem ersten Zeitabschnitt A werden für beide Parameter P1, P2 im Wesentlichen konstante Werte ermittelt, woraus geschlossen werden kann, dass auch das Messmedium im Wesentlichen eine konstante Zusammensetzung hat und die Messwertaufnahme der Messsonde unter im Wesentlichen konstanten Bedingungen erfolgt.

Tritt jedoch eine Veränderung im Prozess auf, z. B. durch Zugabe weiterer Reagenzien und/oder durch eine Änderung der Prozessparameter, so wirkt sich dieses auch auf die Messsonde aus. Die sondenspezifischen Parameter P1, P2 reagieren auf diese Änderung. Der Zeitpunkt t1 markiert eine solche Änderung oder Störung des Messmediums. Wie im Zeitabschnitt B zu erkennen ist, reagiert der erste Parameter P1 sehr schnell auf die Störung. Die Werte des ersten Parameters P1 zeigen eine rasche Anpassung an das veränderte Messmedium. Am Zeitpunkt t2 hat sich der erste Parameter P1 bereits wieder eingependelt und zeigt wieder einen im Wesentlichen konstanten Wert an.

Der zweite Parameter P2 reagiert ebenfalls auf die Störung des Messmediums, allerdings langsamer, wie es in den Zeitabschnitten B und C zu erkennen ist. Am Zeitpunkt t2 ist der Wert des zweiten Parameters P2 noch immer instabil und erst ab dem Zeitpunkt t3 hat sich der zweite Parameter P2 wieder auf einen im Wesentlichen konstanten Wert eingependelt.

Die Bestimmung der beiden Parameter P1, P2 ermöglicht auch eine Aussage über die Funktionsfähigkeit der Messsonde. Ändert sich der Wert eines der beiden Parameter P1, P2 ohne das eine Änderung der Werte des anderen Parameters P1, P2 erfolgt, so kann daraus geschlossen werden, dass die Messsonde nicht mehr optimal funktioniert und eine Überprüfung und/oder ein Austausch durchgeführt werden sollte. Weitere Hinweise auf ein mögliches Fehlverhalten der Messsonde kann ein fehlendes oder zu langsames Einschwingen des ersten und/oder des zweiten Parameters P1, P2 nach einer Störung geben. Derartige Ereignisse werden dem Benutzer angezeigt, vorzugsweise erscheint diese Meldung auf derselben Anzeige welche auch die Messwerte anzeigt. Selbstverständlich ist es auch möglich, dass diese Meldung an ein übergeordnetes System, zum Beispiel eine Leitstelle, weitergeleitet wird.

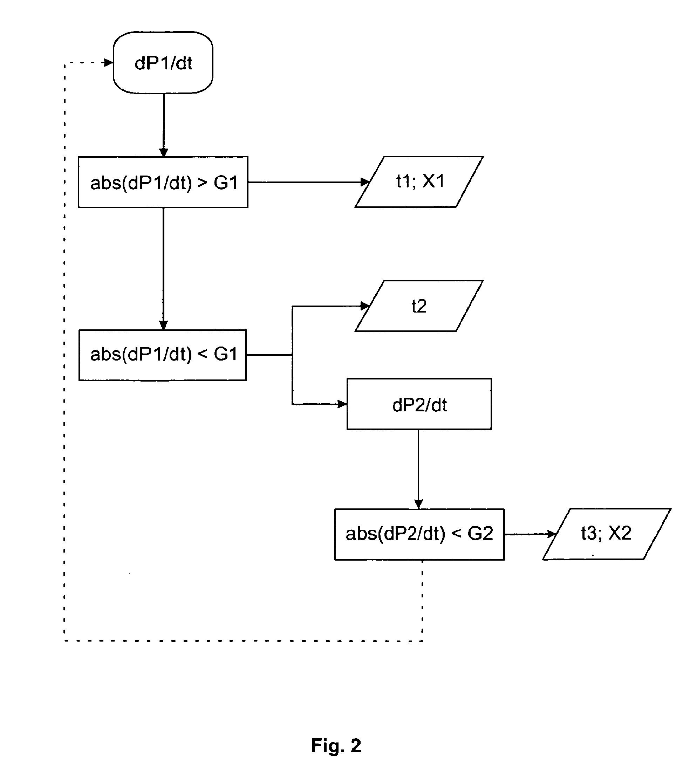

Figur 2 zeigt in Form eines Flussdiagramms eine schematische Darstellung des erfindungsgemässen Verfahrens, welches auf dem in Figur 1 gezeigten Verhalten der beiden Parameter P1, P2 basiert.

Parallel zum Messwert der Messsonde wird auch der Wert des ersten Parameters P1 als Funktion der Zeit t erfasst. Die temporale Ableitung oder Steigung dieses Werts wird ermittelt und ein erster Betrag |dP1/dt| gebildet. Dieser erste Betrag |dP1/dt| wird mit einem ersten Grenzwert G1 verglichen. Wenn dieser erste Betrag |dP1/dt| grösser ist als der erste Grenzwert G1, so wird ein erster Zeitpunkt t1 erfasst, welcher im Wesentlichen dem Zeitpunkt entspricht an dem der Prozess gestört wurde. Der erste Zeitpunkt t1 markiert, wie in Figur 1 gezeigt, den Beginn der Einpendelphase des ersten Parameters P1. Zudem kann auch ein erster Messwert X1 der Messsonde ermittelt werden.

Vom ersten Zeitpunkt t1 an wird nun der Wert des ersten Parameters P1 solange als Funktion der Zeit ermittelt, bis der erste Betrag |dP1/dt| (in den Figuren als abs(dP1/dt) bezeichnet) wieder unter den ersten Grenzwert G1 gesunken ist, also bis der Wert des erste Parameters P1 wieder im Wesentlichen konstant ist. Der zweite Zeitpunkt t2 an dem dieses geschieht, wird wiederum erfasst.

Der zweite Zeitpunkt t2 markiert den Zeitpunkt, an dem sich der erste Parameter P1 wieder auf einen im Wesentlichen konstanten Wert eingependelt hat. Vom zweiten Zeitpunkt t2 an wird nun das Einschwingverhalten des zweiten Parameters P2 verfolgt, indem dessen Wert als Funktion der Zeit erfasst wird. Ein zweiter Betrag |dP2/dt| (in den Figuren als abs(dP2/dt) bezeichnet) wird von der temporalen Ableitung des Werts des zweiten Parameters P2 gebildet. Dieser zweite Betrag |dP2/dt| wird mit einem zweiten Grenzwert G2 verglichen. Der zweite Parameter P2 wird solange überwacht, bis der zweite Betrag |dP2/dt| kleiner ist als der zweite Grenzwert G2. Der dritte Zeitpunkt t3 an dem dieses passiert, markiert den Zeitpunkt an dem sich beide Parameter P1, P2 wieder auf im Wesentlichen konstante Werte eingependelt haben und das Messsystem stabil läuft. Am dritten Zeitpunkt t3 kann nun ein zweiter Messwert X2 aufgenommen werden.

Messungen, welche im Zeitraum zwischen dem ersten und dritten Zeitpunkt t1, t3 durchgeführt werden, unterliegen einer Messunsicherheit, da der Prozess gestört wurde und sich die Messsonde noch nicht an die neuen Verhältnisse angepasst hat. Dieser Zeitraum wird dem Benutzer angezeigt und stellt eine erste Überwachungsgrösse dar.

Die in Figur 1 mit B und C bezeichnete Zeitspanne gibt zudem Aufschluss über das Ansprechverhalten der Messsonde, einer weiteren Überwachungsgrösse. Die Messsonde benötigt diese Zeitspanne, um sich nach einer Störung des Messmediums wieder einzuschwingen. Erfahrungsgemäss verlangsamt sich das Ansprechverhalten mit zunehmender Abnutzung der Messsonde.

Bei Kenntnis des mit der Störung verbundenen Messwertsprungs zwischen dem ersten und zweiten Messwert X1, X2, kann aufgrund der anhand des Verfahrens ermittelten aktuellen Überwachungsgrösse und durch Vergleich mit einer vorgegebenen optimalen Überwachungsgrösse die Restlebensdauer oder der Alterungszustand der Messsonde abgeschätzt und/oder ermittelt werden.

Zusätzlich kann anhand der experimentell erhaltenen Messwerten ein vierter und/oder fünfter Zeitpunkt berechnet werden, an dem der Messwert der Sonde etwa 95% oder etwa 98% des Messwertsprungs oder des Unterschieds zwischen dem ersten und dem zweiten Messwert erreicht. Mittels des vierten und/oder fünften Zeitpunkts kann eine sondenspezifische Grösse ermittelt werden, welche eine Aussage über die Ansprechzeit und somit auch über den Alterungszustand der Messsonde erlaubt.

Selbstverständlich können alle ermittelten Werte direkt abgelesen und ausgewertet werden oder diese können in geeigneter Form elektronisch gespeichert und bearbeitet werden. Die gespeicherten Werte können automatisch ausgewertet und/oder zur nachträglichen Analyse von potentiellen Messfehlern herangezogen werden.

Der erste Parameter P1 wird vorzugsweise zeitgleich mit jedem Messwert als Funktion der Zeit ermittelt. Der zweite Parameter P2 kann beispielsweise nur zwischen den Zeitpunkten t1 und/oder t2 und t3 ermittelt werden oder wie auch der erste Parameter P1 zeitgleich mit jedem Messwert erfasst werden. In Abhängigkeit der verwendeten Messsonde ist auch eine kontinuierliche Erfassung des Messwerts X und/oder der Parameterwerte P1, P2 denkbar.

Figur 3 zeigt eine Auftragung des ORP- und pH-Werts von zwei Messsonden S1, S2 gegen die Zeit während der Zugabe von Salzsäure zu einer wässrigen Lösung mit pH 7. Beide Messsonden S1, S2 sind potentiometrische Sonden von Mettler-Toledo vom Typ InPro 3250SG und wurden zusammen mit einem Transmitter M700 betrieben. Die ORP- und pH-Werte als Funktion der Zeit der ersten Messsonde S1 sind gebrochen und die ORP- und pH-Werte als Funktion der Zeit der zweiten Messsonde S2 durchgezogen dargestellt. Wie in Figur 3 klar zu erkennen ist, reagiert der ORP-Wert beider Messsonden S1, S2 schneller auf die Zugabe von konzentrierter Säure zum Puffer als die pH-Werte. Die ORP-Werte zeigen einen Sprung am Zeitpunkt t1 und sind am Zeitpunkt t2 bereits wieder im Wesentlichen konstant. Die pH-Werte beider Messsonden S1, S2 zeigen hingegen ein verlangsamtes Ansprechverhalten auf die Säure-Zugabe. Der pH-Sprung erfolgt im Wesentlichen erst zwischen den Zeitpunkten t2 und t3. Am Zeitpunkt t3 sind die ORP- und pH-Werte beider Messsonden S1, S2 wieder eingependelt und zeigen im Wesentlichen konstante Werte.

Das erfindungsgemässe Verfahren ermöglicht daher eine benutzerfreundliche und automatische Auswertung der in Figur 3 gezeigten Änderungen der sondenspezifischen Parameter bei einer Störung des Messmediums.

Obwohl die Erfindung durch die Darstellung spezifischer Ausführungsbeispiele beschrieben worden ist, ist es offensichtlich, dass zahlreiche weitere Ausführungsvarianten in Kenntnis der vorliegenden Erfindung geschaffen werden können, beispielsweise indem die Merkmale der einzelnen Ausführungsbeispiele miteinander kombiniert und/oder einzelne Funktionseinheiten der Ausführungsbeispiele ausgetauscht werden.

## Patentansprüche

1. Verfahren zur Überwachung einer Messsonde, insbesondere einer ionensensitiven, amperometrischen, potentiometrischen oder optischen Messsonde, welche in Kontakt mit einem Messmedium steht und welche zur Erfassung eines Messwerts (X) des Messmediums dient, wobei das Verfahren die folgenden Schritte aufweist:
- Bestimmen von zeitabhängigen Werten eines ersten Parameters (P1),
- Ermitteln der temporalen Ableitung der Werte des ersten Parameters (P1) und bilden eines ersten Betrags (|dP1/dt|),
- Vergleichen des ersten Betrags (|dP1/dt|) mit einem ersten Grenzwert (G1), **gekennzeichnet durch**
- Erfassen eines ersten Zeitpunkts (t1) an dem der erste Betrag (|dP1/dt|) den ersten Grenzwert überschreitet,
- vom ersten Zeitpunkt (t1) an Verfolgen der Werte des ersten Parameters (P1) bis zu einem zweiten Zeitpunkt (t2) an dem der erste Betrag (|dP1/dt|) den ersten Grenzwert (G1) unterschreitet,
- vom zweiten Zeitpunkt (t2) an Bestimmen von zeitabhängigen Werten eines zweiten Parameters (P2),
- Ermitteln der temporalen Ableitung der Werte des zweiten Parameters (P2) und bilden eines zweiten Betrags (|dP2/dt|),
- Vergleichen des zweiten Betrags ([dP2/dt|) mit einem zweiten Grenzwert (G2) bis zu einem dritten Zeitpunkt (t3) an dem der zweite Betrag (|dP2/dt|) den zweiten Grenzwert (G2) unterschreitet,
- Ermitteln einer Überwachungsgrösse der Messsonde, welche mit den ermittelten ersten, zweiten und/oder dritten Zeitpunkten (t1, t2, t3) in Zusammenhang steht,
wobei der erste Parameter (P1) schneller auf Änderungen eines Prozesses, welchem das Messmedium unterworfen wird, anspricht als der zweite Parameter (P2), und wobei beide Parameter (P1, P2) sondenspezifische Parameter sind.

2. Verfahren nach Anspruch 1, **dadurch gekennzeichnet, dass** das Verfahren einen Vergleich des Verhaltens der Messwerte von zwei oder mehr sondenspezifischen Parametern umfasst.

3. Verfahren nach Anspruch 1 oder 2, **dadurch gekennzeichnet, dass** die Überwachungsgrösse das relative Ansprechverhalten (A) der Messsonde ist, dessen Ermittlung die folgenden Schritte umfasst:
- Erfassen eines ersten Messwerts (X1) am ersten Zeitpunkt (t1),
- Erfassen eines zweiten Messwerts (X2) am dritten Zeitpunkt (t3),
- Ermitteln der Differenz des ersten und zweiten Messwerts (X1, X2)
- Ermitteln der Differenz des dritten und ersten Zeitpunkts (t1, t3).

4. Verfahren nach einem der Ansprüche 1 bis 3, **dadurch gekennzeichnet, dass** dieses weiterhin die Bestimmung eines vierten und/oder fünften Zeitpunkts (t4, t5), welche etwa 95% und etwa 98% des Unterschied zwischen dem ersten und zweiten Messwerts entsprechen, und die Bestimmung einer sondenspezifische Grösse anhand des vierten und/oder fünften Zeitpunkts umfasst.

5. Verfahren nach einem der Ansprüche 1 bis 4, **dadurch gekennzeichnet, dass** dieses weiterhin folgende Schritte umfasst:
- Speichern der ermittelten Überwachungsgrösse und
- Ermitteln einer Restlebensdauer der Messsonde.

6. Verfahren nach Anspruch 5, **dadurch gekennzeichnet, dass** die Restlebensdauer durch Vergleich des Werts der aktuellen Überwachungsgrösse mit dem Wert einer optimalen Überwachungsgrösse ermittelt wird.

7. Verfahren nach einem der Ansprüche 1 bis 4, **dadurch gekennzeichnet, dass** die Überwachungsgrösse die Messwertstabilität ist, wobei anhand des erfassten ersten und dritten Zeitpunkts (t1, t3) ein Zeitfenster ermittelt wird, in welchem die Messsonde instabile Messwerte (X) liefert, und dieses Zeitfenster einem Benutzer angezeigt wird.

8. Verfahren nach einem der Ansprüche 1 bis 7, **dadurch gekennzeichnet, dass** der erste Parameter und der zweite Parameter
- das Oxidations-Reduktionspotential (ORP) und einen ersten Glaswert (U_{glas1}-U_{SG}),
- einen ersten Referenzwert (Ref1) und einen zweiten Referenzwert (Ref2),
- das Oxidations-Reduktionspotential (ORP) und ein Messwertpotential (U_{pH}), oder
- den ersten Glaswert (Ugₗₐₛ₁-U_{SG}) und einen zweiten Glaswert (U_{glas2}-U_{SG}) umfassen.

9. Verfahren nach einem der Ansprüche 1 bis 8, **dadurch gekennzeichnet, dass** das Verfahren ein dynamisches Verfahren ist, welches im Betrieb der Messsonde durchgeführt wird.

10. Messsystem zur Durchführung des Verfahrens nach einem der Ansprüche 1 bis 9, mit einer Messsonde, insbesondere einer ionensensitiven, amperometrischen, potentiometrischen oder optischen Messsonde, mit einem Transmitter und mit einem Controller, wobei die Messsonde mit einem Messmedium in Kontakt steht und der Controller eine Computereinheit und mindestens ein Programm aufweist,
**dadurch gekennzeichnet, dass** das Programm das Verfahren nach einem der Ansprüche 1-9 durchführt, wenn es auf der Computereinheit abläuft.

11. Messsystem nach Anspruch 10, **dadurch gekennzeichnet, dass** die Messsonde eine potentiometrische Messsonde mit einer Messelektrode, mindestens einer Referenzelektrode und mindestens einem ionensensitiven Glas ist.

12. Messsystem nach Anspruch 10 oder 11, **dadurch gekennzeichnet, dass** der Controller und der Transmitter eine Einheit bilden.

## Claims

1. Method of monitoring a measuring probe, in particular an ion-sensitive, amperometric, potentiometric or optical measuring probe, which is in contact with a measurement medium and serves to acquire at least one measurement value (X) of the measurement medium, said method comprising the following steps:
- measuring time-dependent values of a first parameter (P1);
- determining the time derivative for the values of the first parameter (P1) and establishing a first absolute value (|dP1/dt|);
- comparing said first absolute value (|dP1/dt|) to a first threshold value (G1);
**characterized in**
- registering a first point in time (t1), when the first absolute value (|dP1/dt|) exceeds the first threshold value;
- starting at this first point in time (t1), monitoring the values of the first parameter (P1) up to a second point in time (t2), when the first absolute value (|dP1/dt|) falls below the first threshold value (G1);
- from the second point in time (t2), measuring time-dependent values of a second parameter (P2);
- determining the time derivative for the values of the second parameter (P1) and establishing a second absolute value (|dP2/dt|);
- comparing said second absolute value (|dP2/dt|) to a second threshold value (G2) up to a third point in time (t3), when the second absolute value (|dP2/dt|) falls below the second threshold value (G2);
- determining a monitoring quantity of the measuring probe which is connected to said first, second and/or third points in time (t1, t2, t3);
wherein the first parameter (P1) responds faster than the second parameter (P2) to changes of a process to which the measurement medium is subjected, and wherein both parameters (P1, P2) are probe-specific parameters.

2. Method according to claim 1, **characterized in that** the method comprises a comparison of the behavior of the measurement values of two or more probe-specific parameters.

3. Method according to claim 1 or 2, **characterized in that** the monitoring quantity is the relative response behavior (A) of the measuring probe, which determination comprises the following steps:
- registering a first measurement value (X1) at the first point in time (t1);
- registering a second measurement value (X2) at the third point in time (t3);
- determining the difference between the first measurement value (X1) and the second measurement value (X2);
- determining the time interval between the first point in time (t1) and the third point in time (t3).

4. Method according to one of the claims 1 to 3, **characterized in that** said method further comprises determining a fourth and/or fifth point in time (t4, t5) which correspond, respectively, to about 95% and about 98% of the difference between the first and second measurement values; and calculating a probe-specific quantity based on the fourth and/or fifth point in time.

5. Method according to one of the claims 1 to 4, **characterized in that** said method further comprises the following steps:
- storing the probe-specific monitoring quantity in a memory, and
- determining a remaining operating life of the measuring probe.

6. Method according to claim 5, **characterized in that** the remaining operating life is determined by comparing the current value of the monitoring quantity to an optimal value for the monitoring quantity.

7. Method according to one of the claims 1 to 4, **characterized in that** the monitoring quantity is the stability of the measurement values wherein, based on the first and third points in time (t1, t3) that were registered, a time window is determined during which the measuring probe delivers unstable measurement values (X), and wherein said time window is brought to the attention of a user.

8. Method according to one of the claims 1 to 7, **characterized in that** the first parameter and the second parameter comprise:
- the oxidation-reduction potential (ORP) and a first glass value (U_{glas1}-U_{SG}),
- a first reference value (Ref1) and a second reference value (Ref2),
- the oxidation-reduction potential (ORP) and a measurement value potential (U_{pH}),
or
- the first glass value (U_{glas1}-U_{SG}) and a second glass value (U_{glas2}-U_{SG}).

9. Method according to one of the claims 1 to 8, **characterized in that** the method is a dynamic method which is performed while the measuring probe is in operation.

10. Measuring system designed to perform the method according to one of the claims 1 to 9, with a measuring probe, specifically an ion-sensitive, amperometric, potentiometric or optical measuring probe, with a transmitter and with a controller, wherein the measuring probe is in contact with a measurement medium and the controller comprises a computer unit and at least one program, **characterized in that** the program performs the method according to one of the claims 1 to 9, when it is executed on the computer unit.

11. Measuring system according to claim 10, **characterized in that** the measuring probe is a potentiometric measuring probe with a measuring electrode, at least one reference electrode and at least one ion-sensitive glass.

12. Measuring system according to claim 10 or 11, **characterized in that** the controller and the transmitter form a common unit.

## Revendications

1. Procédé pour surveiller une sonde de mesure, en particulier une sonde de mesure sensible aux ions, ampérométrique, potentiométrique ou optique, laquelle est en contact avec un fluide de mesure et sert à la détermination d'une valeur de mesure (X) du fluide de mesure, le procédé comportant les étapes suivantes :
- détermination de valeurs dépendantes du temps pour un premier paramètre (P1),
- détection de la dérivée temporelle des valeurs du premier paramètre (P1) et formation d'un premier montant (d|dP1/dt|),
- comparaison du premier montant (d|dP1/dt|) avec une première valeur seuil (G1), **caractérisé par**
- la détection d'un premier instant (t1) auquel le premier montant (d|dP1/dt|) dépasse la première valeur seuil,
- à partir du premier instant (t1), suivi des valeurs du premier paramètre (P1), jusqu'à un deuxième instant (t2) auquel le premier montant (d|dP1/dt|) tombe en-dessous de la première valeur seuil (G1),
- à partir du deuxième instant (t2), détermination de valeurs dépendantes du temps pour un deuxième paramètre (P2),
- détection de la dérivée temporelle des valeurs du deuxième paramètre (P2) et formation d'un deuxième montant (d|dP2/dt|),
- comparaison du deuxième montant (d|dP2/dt|) avec une deuxième valeur seuil (G2), jusqu'à un troisième instant (t3) auquel le deuxième montant (d|dP2/dt|) tombe en-dessous de la deuxième valeur seuil (G2),
- détermination d'une grandeur de surveillance de la sonde de mesure, laquelle dépend des premier, deuxième et/ou troisième instants déterminés (t1, t2, t3),
dans lequel le premier paramètre (P1) réagit plus rapidement à des changements d'un processus, auquel est soumis le fluide de mesure, que le deuxième paramètre (P2), et dans lequel les deux paramètres (P1, P2) sont des paramètres spécifiques à la sonde.

2. Procédé selon la revendication 1, **caractérisé en ce que** le procédé comprend une comparaison du comportement des valeurs de mesure de deux ou plusieurs paramètres spécifiques à la sonde.

3. Procédé selon la revendication 1 ou 2, **caractérisé en ce que** la grandeur de surveillance est la réponse relative (A) de la sonde de mesure, dont la détermination comprend les étapes suivantes :
- détection d'une première valeur de mesure (X1) au premier instant (t1),
- détection d'une deuxième valeur de mesure (X2) au troisième instant (t3),
- détermination de la différence entre les première et deuxième valeurs de mesure (X1, X2),
- détermination de la différence entre les troisième et premier instants (t1, t3).

4. Procédé selon l'une des revendications 1 à 3, **caractérisé en ce que** celui-ci comprend en outre la détermination d'un quatrième et/ou d'un cinquième instant(s) (t4, t5), correspondant à environ 95% et environ 98% de la différence entre la première et la deuxième valeur de mesure, ainsi que la détermination d'une grandeur spécifique à la sonde à l'aide du quatrième et/ou du cinquième instant(s).

5. Procédé selon l'une des revendications 1 à 4, **caractérisé en ce que** celui-ci comprend en outre les étapes suivantes :
- enregistrement de la grandeur de surveillance déterminée, et
- détermination d'une durée de vie résiduelle de la sonde de mesure.

6. Procédé selon la revendication 5, **caractérisé en ce que** la durée de vie résiduelle est déterminée par la comparaison des valeurs de la grandeur de surveillance actuelle avec la valeur d'une grandeur de surveillance optimale.

7. Procédé selon l'une des revendications 1 à 4, **caractérisé en ce que** la grandeur de surveillance est la stabilité des valeurs de mesure, dans lequel une fenêtre temporelle, dans laquelle la sonde de mesure fournit des valeurs de mesure instables (X), est déterminée à l'aide des premier et troisième instants détectés (t1, t3), et dans lequel cette fenêtre temporelle est indiquée à un utilisateur.

8. Procédé selon l'une des revendications 1 à 7, **caractérisé en ce que** le premier paramètre et le deuxième paramètre comprennent :
- le potentiel de réduction d'oxydation (ORP) et une première valeur de verre (U_{glas1}-U_{glas2}),
- une première valeur de référence (Ref1) et une deuxième valeur de référence (Ref2),
- le potentiel de réduction d'oxydation (ORP) et un potentiel de valeur de mesure (U_{pH}), ou
- la première valeur de verre (U_{glas1}-U_{SG}) et une deuxième valeur de verre (U_{glas2}-U_{SG}).

9. Procédé selon l'une des revendications 1 à 8, **caractérisé en ce que** le procédé est un procédé dynamique, exécuté pendant le fonctionnement de la sonde.

10. Système de mesure pour l'exécution du procédé selon l'une des revendications 1 à 9, avec une sonde de mesure, en particulier une sonde de mesure sensible aux ions, ampérométrique, potentiométrique ou optique, avec un transmetteur et avec un contrôleur, dans lequel la sonde de mesure est en contact avec un fluide de mesure, et le contrôleur comporte une unité informatique et au moins un programme,
**caractérisé en ce que** le programme exécute le procédé selon l'une des revendications 1 à 9, lorsqu'il se déroule sur l'unité informatique.

11. Système de mesure selon la revendication 10, **caractérisé en ce que** la sonde de mesure est une sonde de mesure potentiométrique, avec une électrode de mesure, au moins une électrode de référence et au moins un verre sensible aux ions.

12. Système de mesure selon la revendication 10 ou 11, **caractérisé en ce que** le contrôleur et le transmetteur forment une unité.
